Europäisches Patentamt

European Patent Office

Office européen des brevets

(19)

(11) Publication number: **0 373 712**
**A2**

# EUROPEAN PATENT APPLICATION

(12)

(21) Application number: **89203137.8**

(22) Date of filing: **11.12.89**

(51) Int. Cl.⁵: **H02H 3/20**

(30) Priority: **15.12.88 GB 8829267**

(43) Date of publication of application:
**20.06.90 Bulletin 90/25**

(84) Designated Contracting States:
**DE FR GB IT**

(71) Applicant: **N.V. Philips' Gloeilampenfabrieken**
**Groenewoudseweg 1**
**NL-5621 BA Eindhoven(NL)**

(72) Inventor: **Schoofs, Franciscus Adrianus**
**Cornelis Maria**
**c/o INT. OCTROOIBUREAU B.V. Prof.**
**Holstlaan 6**
**NL-5656 AA Eindhoven(NL)**

(74) Representative: **Schouten, Frans et al**
**INTERNATIONAAL OCTROOIBUREAU B.V.**
**Prof. Holstlaan 6**
**NL-5656 AA Eindhoven(NL)**

(54) **Excess voltage protection circuit.**

(57) An excess voltage protection circuit for a d.c. voltage supply has supply lines (10/13,11/14) for connection to a device to be powered. One of the supply lines (10/13) has a switching transistor (T1) connected in series in the line. A control circuit (15) is responsive to a voltage detector circuit (16) coupled with the supply line (10/13). When an excess voltage occurs the detector circuit (16) causes the control circuit to trigger the switching transistor to a non conductive state and thereby prevents exposure of subsequent circuitry to excess voltages. The switching transistor (T1) may be fabricated on an integrated chip by the resurf principle together with the control circuit (15) and the voltage detector circuit (16) employing semiconductor devices with reduced breakdown voltage with respect to the input voltage of the system.

FIG.1

## EXCESS VOLTAGE PROTECTION CIRCUIT

This invention relates to an excess voltage protection circuit and more particularly to a protection circuit suitable for semiconductor integration in circuits operated from rectified a.c. mains voltages.

The present invention results from a consideration of the requirements for powering miniature fluorescent lamps intended to form substitutes for conventional incandescent lamps, but is applicable to other applications examples of such fluorescent lamps are the so called SL and PL types. Such lamps are required to be operated directly from a mains power souce via for example an input filter, a clamping circuit and rectifier.

Problems arise in such circuits in that in addition to 230 volts RMS the mains also carries voltage fluctuations of up to 60% together with transients of kilovolt and kiloamp magnitude. With a view to miniaturisation and cost saving it is desirable to produce the drive circuits for a fluorescent lamp by an integrated circuit process and such a circuit must accordingly be capable of withstanding voltages higher than 230V.RMS.

The voltage supply from the mains can be limited to 750V peak in a relatively cheap manner by means of a resistor (10 ohms) in series with the mains followed by a voltage dependant resistor clamp across the input to or output of the subsequent circuit. Although transistors capable of operating at 750V are producible it is difficult to provide them in integrated form. Accordingly, the present invention proposes an excess voltage protection circuit which enables limitations of voltage to a lower value so that lower voltage rated transistors can be employed in subsequent circuitry.

According to the invention there is provided an excess voltage protection circuit for a d.c. voltage supply the protection circuit having supply lines for connection to a device to be powered, characterised in that one of the supply lines has a switching transistor connected in series and a control circuit is responsive to a voltage detector circuit coupled with the supply line and is effective to trigger the switching transistor to a non conductive state upon detection of an excess voltage.

In this way the circuit voltage following the switching transistor is prevented from exceeding the voltage rating for conventional transistor circuitry.

The protection capability of the circuit can be enhanced by the provision of a current detector circuit which is responsive to the current flow in one of the lines and is effective to trigger the switching transistor to a non conductive state upon detection of an excess current flow in the supply line.

Preferably, the or each detector circuit and the control circuit are coupled with and powered from the supply lines.

The switching transistor may be fabricated by the resurf principle and integrated on a common semiconductor chip with the control circuit and the or each detector circuit.

Preferably the switching transistor has a high voltage input provided via a supply wire connected to a bonding pad on the integrated circuit structure, the transistor being formed by layers surrounding the pad.

This construction means that no wiring which is required to carry very high voltages is required on the surface of the integrated circuit thereby simplifying the process and layout of the chip.

In an advantageous construction the switching transistor is of the field effect type having a gate connected to a source of triggering voltage, the drain to source path of which switching transistor is in series with one of the supply lines and is coupled with the other one of the supply lines via a resistor in series with a zener diode which defines the maximum voltage for d.c. supply, the control circuit comprises a degenerate thyristor connected between the gate and the source of the switching transistor, the voltage detector circuit comprises a transistor the emitter collector path of which is connected between one end of the zener diode and a triggering input of the thyristor, the base of which transistor is coupled with the end of the resistor remote from the zener diode such that the transistor is caused to conduct when there is an overvoltage thereby to trigger the thyristor into conduction and cause the switching transistor to be triggered to a non conductive state.

The current detector circuit may comprise a second resistor connected in series with the switching transistor in the supply line and a transistor having its base coupled to the supply line on the switching transistor side of the second resistor, its emitter coupled to the supply line to the opposite side of the second resistor and its collector coupled with the triggering input of the thyristor such than an excess current through the second resistor triggers the transistor into conduction and causes the switching transistor to be triggered to a non conductive state. This arrangement provides protection against the drawing of excess current by circuits fed from the voltage supply line.

According to another aspect of the invention there is provided a direct current power supply circuit characterised in the combination of a voltage clamp coupled in parallel with a pair of input lines for a source of alternating current, a rectifier circuit coupled with the output of the voltage clamp and an excess voltage protection circuit as previously defined the supply lines of which are connected to the output of the rectifier circuit. This arrangement provides a d.c. supply from an a.c. mains source and is protected against excess voltages.

In a specific application of the invention there is provided a fluorescent lamp unit, characterised in the combination of a fluorescent tube a switched mode power converter and a direct current power supply as previously defined. The tube, power converter and direct current power supply may be incorporated in a housing which is equipped with a connector portion, that permits removeably electrical coupling with a socket for an incandescent light bulb. Alternatively, the power converter and direct current power supply may be incorporated in a lamp socket or luminaire which is adapted to receive a removeable fluorescent tube.

In order that the invention and its various other preferred features may be understood more easily, some embodiments thereof will now be described, by way of example only, with reference to the drawings, in which:-

Figure 1 is a schematic circuit diagram of an excess voltage protection circuit constructed in accordance with the invention,

Figure 2 is another embodiment of an excess voltage protection circuit constructed in accordance with the invention,

Figure 3 is a cross sectional view of part of an integrated circuit chip showing a double-acting resurf structure forming a switching transistor for the circuit of Figures 1 and 2,

Figure 4 is a block diagram illustrating a particular application of the excess voltage protection circuit in accordance with another aspect of the invention, and

Figure 5 is a side view of a fluorescent lamp unit which incorporates an excess voltage protection circuit.

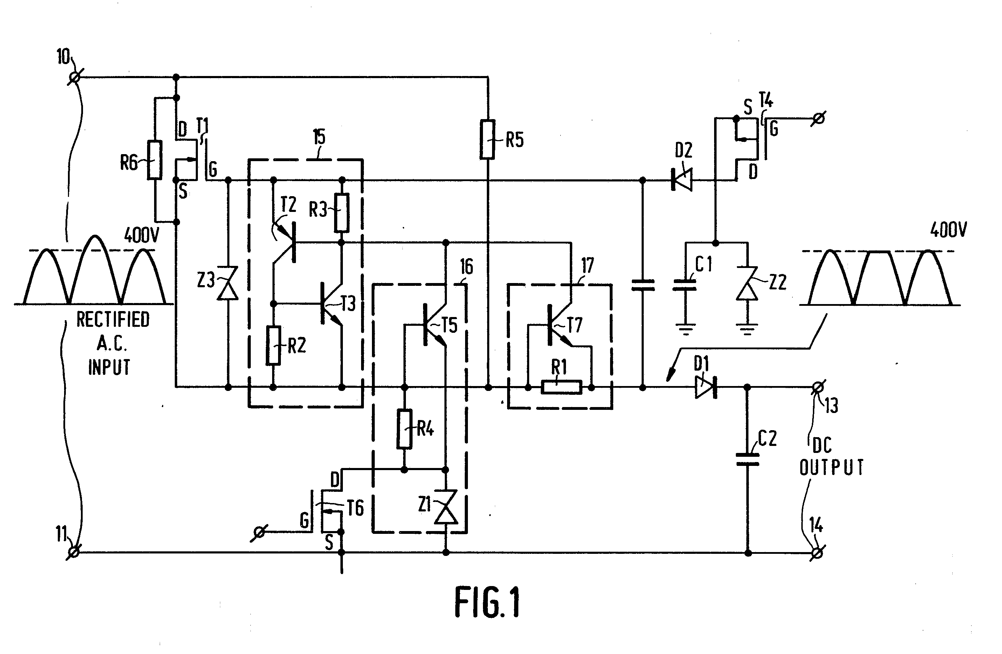

Referring now to Figure 1 the voltage protection circuit has a pair of input lines 10,11 for connection to a source of rectified a.c. mains. One of the input lines 10 is connected via a switching transistor T1, shown for example as a NMOS type, a resistor R1 and diode D1 to an output terminal 13 whilst the other input terminal 11 is connected directly to an output terminal 14. The source of the transistor T1 is coupled via a resistor R4 and a zener diode 71 to the direct connection between input terminal 11 and output terminal 14 and serves to define the maximum output voltage between terminals 13 & 14. The gate to source path of the transistor T1 is bridged by a control circuit 15 which is formed by a degenerate thyristor circuit comprising in this example a pnp transistor T2 having its emitter coupled to the gate of T1 its collector connected via a resistor R2 to the source of T1 and its base connected to the collector of an npn transistor T3 of the thyristor. The transistor T3 also has its collector connected to the gate of T1 via a resistor R3 and its emitter connected to the source electrode of T1. The gate of transistor T1 is connected via a blocking diode D2 to the drain of a field effect transistor T4 the source of which is connected to a 15 volt supply line. The circuitry coupled with the supply line 10/13 and fed from the line 10 floats in voltage up and down with the rectified mains voltage. The transistor T4 serves to allow conduction of the transistor T1 in response to a control signal applied to the gate of transistor T4 either from a remote source or by a manual switch. In it normal state T4 is arranged to be on and applies a 15 volt switch on voltage to the gate G of T1 whilst the thyristor circuit is off.

A voltage detector circuit 16 is provided which comprises the resistor R4 and an npn transistor T5 the base of which is connected to that side of resistor R4 which is connected to the source of T1 whilst the emitter is connected to the other side of the resistor R4. The collector electrode of T5 is coupled with the collector of transistor T3 of the thyristor circuit. When the output voltage on line 13 rises above the zener voltage of Z1 the current through R4 causes T5 to be switched on which in turn causes the triggering of the thyristor, discharge of Cgs of T1 and switch off of the transistor T1 and prevents the output voltage from rising in response to short term peaks of input voltage.

In order to switch the thyristor on and thereby turn off T1 there is provided a transistor T6 the drain to source path of which is connected across the zener diode Z1. In response to a control signal on the gate of T6 either provided remotely or via a mechanical switch the zener diode Z1 can be effectively bypassed causing an increase of current through R4 and the consequential switching on of transistor T5 thereby triggering the thyristor to switch on and the transistor T1 to be switched off. When capacitor C2 has been charged the transistor T7 is switched on at each zero crossing to provide a path to ground so that the voltage between gate and source of T is restored to approximately 15 volts.

An output current circuit 17 is also provided this comprising an npn transistor T7 in combination with the resistor R1. The base of T7 is connected to the side of R1 which is coupled to the transistor T1, the emitter of T7 is connected to the other side of R1 and the collector is connected to the triggering input of the thyristor on the collector of T3. When the current through R1 causes the voltage developed across it to be sufficient to trigger T7 into conduction then the thyristor is caused to conduct and T1 is switched off until the next zero crossing of the mains voltage.

The transistor T4 is provided with a 15 volt supply derived from the rectified a.c. input voltage. For this purpose a 15 volt zener diode Z2 with a parallel smoothing capacitor C2 is connected between the source of T1 and a ground reference line. The source of transistor T4 is fed directly from the zener diode Z2. In order to provide some current flow from node 10 to node 13 when T1 is switched off (e.g. during start up) a resistor R6 (e.g. 10 KOhms) may be connected between drain and source of T1.

A zener diode Z3 of say 22 volts may be connected between gate and source of transistor circuit T1 to protect the thyristor and subsequent circuitry against overvoltage.

It will be appreciated that although the circuit of Figure 1 is made up of transistors of specific polarity types, a similar arrangement can be produced with transistors of opposite polarity types and such arrangements are intended to fall within the scope of this invention.

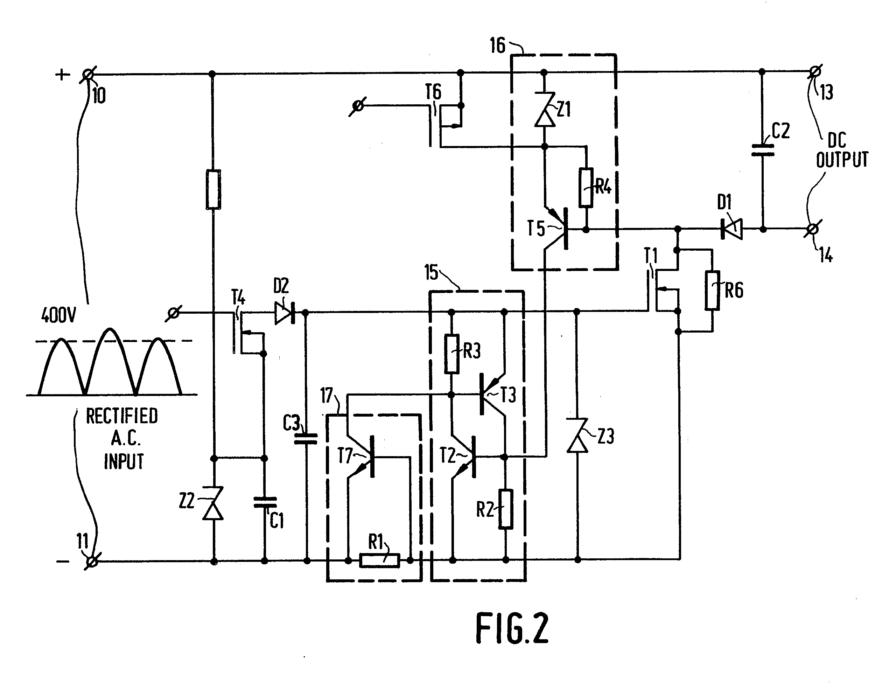

An alternative embodiment is shown in Figure 2 in which the same reference numerals have been given to components functioning similarly to components in Figure 1. The similarity of this circuit to that of Figure 1 will be readily appreciated and as its operation is similar to that of Figure 1 it will not be described in detail.

The switching transistor T1 is in this case applied in the "return" path (connection between nodes 11 and 14). This may yield an advantageous system in the case where lower breakdown voltages can be tolerated, e.g. in the USA, and breakdown of wiring on the surface of the semiconductor chip is less of a problem. In this situation a high voltage lateral DMOS transistor may be employed with its drain wiring running also at the surface of the semiconductor chip. Similarly to Figure 1 there is still the big advantage that the remainder of the devices may have a lower breakdown voltage as is generally the case with the attractive vertical DMOS transistors. The thyristor has two trigger inputs i.e. the base of T2 and T3. In this "inverted" configuration the base of T3 must be used as trigger input of the control circuit (15).

A particular advantage of the described circuitry is that it can be fabricated on an integrated circuit chip employing the resurf principle to form a lateral DMOS transistor for T1 together with vertical or lateral DMOS transistors with a lower breakdown voltage compared to T1 for the control and detector circuits as well as for the subsequent circuitry. The resurf principle and its applications are documented in proceedings of the International Devices Meeting 1979 pages 238-41, 1980 pages 87-99 and 1982 pages 81 to 83. Further information is available in our British Patents Nos. 2013029B, 2026339B, 2026240B.

Figure 2 shows a cross section of part of an integrated circuit version of the circuit of Figure 1 showing how the transistor T1 is fabricated so as to operate with the resurf effect. This is the only transistor that is required to carry the full peak voltage fluctuations provided by the rectified a.c. input and only the drain D has an electrical connection at that voltage. It is difficult to provide on the chip conductors which will carry such voltages so the resurf principle permits the drain D to be provided with a pad to which an electrical wire is directly connected. This wire forms the input 10 shown in Figure 1. In addition the source-following capability of T1 may be limited (e.g.lower punch-through voltage from source to the substrate).

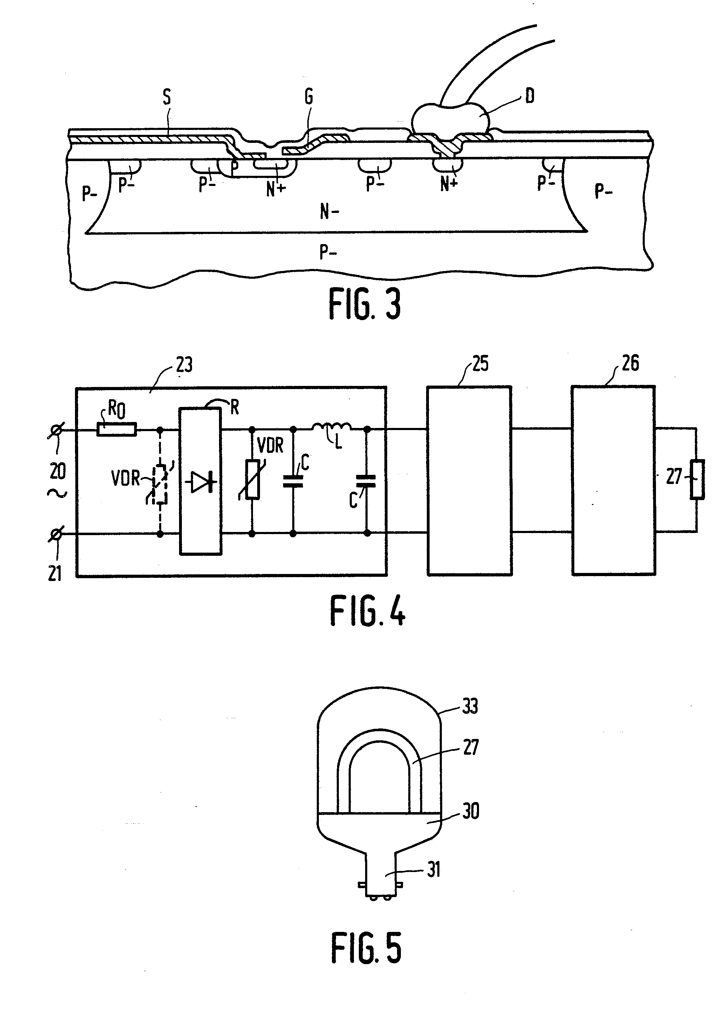

Figure 3 shows a further aspect of the invention where the protection circuit is employed in a high voltage power supply which derives its source of power from the a.c. mains. The power supply has a pair of input terminals 20,21 for connection to the a.c. mains which are connected to a voltage clamp and recifier circuit 23. The voltage clamp is formed by a series arrangement of resistor RD and a voltage dependant resistor VDR. VDR may be connected in parallel with the output of the rectifier circuit R as shown in dotted lines, or alternatively may be connected in parallel with the input of the rectifier circuit R, as shown by dotted lines. This depends upon the relative prices of suitable protection components and the integration process connected between the input terminals. An output from the voltage clamp is coupled via a filter to a protection circuit 25 as described in connection with Figures 1 and 2. Alternatively, the filter circuit could be connected before the rectifier circuit. The output of the protection circuit is connected to a switched mode power converter 26 the output of which is connected to a load L for example a fluorescent lamp. As already described the protection circuit 25 can be fabricated on a semiconductor chip and this and the remainder of the circuits 23, and 26 can be built into the housing of a miniature fluorescent lamp together with the tube itself. Such an arrangement is illustrated in outline in Figure 4 which shows the side view of a fluorescent lamp unit comprising a base 30 having a bayonet connector 31 for removeable connection of the lamp in a socket such as is employed for incandescent bulbs. The base unit contains the circuitry as described in relation to Figure 1 to 3 and the fluorescent tube 27 forming a load for the circuit which tube is contained within a housing 33.

The supply circuits for a fluorescent lamp may alternatively be provided in a lamp socket or luminaire which is adapted to receive a removeable fluorescent tube.

Although the latter part of this description has been directed to the provision of a miniature fluorescent lamp unit it will be appreciated that the invention has other applications for example the supply of power to:-

Electronic bridge circuits suitable for providing a primary voltage for ferrite transformers in power supplies,

Bridge circuits suitable for low power motors.

Control electronics for discrete transistors,

Shavers,

Chargers for batteries e.g. in nickle cadmiun rechargeable devices.

## Claims

1. An excess voltage protection circuit for a d.c. voltage supply the protection circuit having supply lines (10/13, 11/14) for connection to a device to be powered, characterised in that one of the supply lines (10/13) has a switching transistor (T1) connected in series, a control circuit (15) is responsive to a voltage detector circuit (16) coupled with the supply line (10/13) and is effective to trigger the switching transistor (T1) to a non conductive state upon detection of an excess voltage.

2. A circuit as claimed in claim 1, characterised in that a current detector circuit (17) is provided which is responsive to the current flow in one of the lines (10/13) and is effective to trigger the switching transistor (T1) to a non conductive state upon detection of an excess current-flow in the supply line (10/13).

3. A circuit as claimed in claim 1 or 2, characterised in that the or each detector circuit (16,17) and the control circuit (15) are coupled with and powered from the supply lines (10/13,11/14).

4. A circuit as claimed in any one of the preceding claims, characterised in that the switching transistor (T1) is fabricated by the resurf principle and is integrated on a common semiconductor chip with the control circuit (15) and the or each detector circuit (16,17).

5. A circuit as claimed in claim 4, characterised in that the switching transistor (T1) has a high voltage input provided via a supply wire (w) connected to a bonding pad on the integrated circuit structure, the transistor being formed by layers surrounding the pad.

6. A circuit as claimed in any one of the preceding claims, characterised in that the switching transistor (T1) is of the field effect type having a gate (G) coupled with a source of triggering voltage, the drain to source path of which switching transistor is in series with one of the supply lines (10/13, 11/14) and is coupled with the other one of the supply lines (11/14, 10/14) via a resistor (R4) in series with a zener diode (Z1) which defines the maximum voltage for d.c. supply, the control circuit comprises a degenerate thyristor configuration (T2,R2,T3,R3) connected between the gate (G) and the source (S) of the switching transistor (T1), the voltage detector circuit comprises a transistor (T5) the emitter collector path of which is connected between one end of the zener diode (Z1) and a triggering input of the thyristor, the base of which transistor is coupled with the end of the resistor (R4) remote from the zener diode (Z1) such that the transistor (T5) is caused to conduct when there is an overvoltage thereby to trigger the thyristor into conduction and cause the switching transistor (T1) to be triggered to a non conductive state.

7. A circuit as claimed in claim 6 when dependant from claim 2, characterised in that the current detector circuit (17) comprises a second resistor (R1) connected in series with the switching transistor (T1) in the supply line (10/13, 11/14) and a transistor (T7) having its base coupled to the supply line (10/13, 11/14) on the switching transistor side of the second resistor (R1), its emitter coupled to the supply line to the opposite side of the second resistor (R1) and its collector coupled with the triggering input of the thyristor (15) such that an excess current through the second resistor (R1) triggers the transistor (T7) into conduction and causes the switching transistor (T1) to be triggered to a non conductive state.

8. A direct current power supply circuit characterised in the combination of a voltage clamp and rectifier circuit (23) fed from a pair of input lines (20,21) for a source of alternating current, which clamp and rectifier circuit (23) feeds an excess voltage protection circuit (25) as claimed in any one of the preceding claims.

9. A fluorescent lamp unit, characterised in the combination of a fluorescent tube (27) a switched mode power converter (26) and a direct current power supply (23,25) as claimed in claim 8.

10. A fluorescent lamp unit as claimed in claim 9, characterised in that the tube (27), power converter (26) and direct current power supply (23,25) are incorporated in a housing (33) which is equipped with a connector portion (31) that permits removeably electrical coupling with a socket for an incandescent light bulb.

11. A fluorescent lamp unit as claimed in claim 9, characterised in that the power converter and direct current power supply (23,25) are incorporated in a lamp socket or luminaire which is adapted to receive a removeable fluorescent tube.

FIG.1

EP 0 373 712 A2

FIG.2

EP 0 373 712 A2

FIG. 3

FIG. 4

FIG. 5